# FASCICULE DE BREVET EUROPEEN

(11) **EP 3 532 648 B1**
(45) Date de publication et mention de la délivrance du brevet: **25.11.2020**
(21) Numéro de dépôt: 17797697.4
(22) Date de dépôt: 24.10.2017
(51) Int. Cl.: C22C 19/05

(54) **SUPERALLIAGE A BASE DE NICKEL, AUBE MONOCRISTALLINE ET TURBOMACHINE.**
SUPERLEGIERUNG AUF DER BASIS VON NICKEL, EINKRISTALLINE TURBINENSCHAUFEL UND STRÖMUNGSMASCHINE
NICKEL BASED SUPERALLOY, SINGLE CRYSTAL BLADE AND TURBOMACHINE

(30) Priorité: 25.10.2016 FR 1660337
(43) Date de publication de la demande: 04.09.2019
(73) Titulaire: Safran, 75015 Paris (FR); Safran Aircraft Engines, 75015 Paris (FR); Office National d'Etudes et de Recherches Aérospatiales, 91120 Palaiseau (FR); Safran Helicopter Engines, 64510 Bordes (FR)
(72) Inventeur: RAME, Jérémy, 77550 Moissy-Cramayel (FR); BELAYGUE, Philippe, 77550 Moissy-Cramayel (FR); CARON, Pierre, 91940 Les Ulis (FR); DELAUTRE, Joël, 77550 Moissy-Cramayel (FR); JAQUET, Virginie, 77550 Moissy-Cramayel (FR); LAVIGNE, Odile, 75013 Paris (FR)
(74) Mandataire: Cabinet Beau de Loménie
(86) Numéro de dépôt international: PCT/FR2017/052918
(87) Numéro de publication internationale: WO 2018/078269

(56) Documents cités:
- EP-A1- 0 971 041
- EP-A1- 1 211 336
- EP-A1- 1 975 261
- WO-A1-02/22901
- WO-A1-02/070764

## Description

### Arrière-plan de l'invention

Le présent exposé concerne des superalliages à base de nickel pour des turbines à gaz, notamment pour les aubes fixes, aussi appelées distributeurs ou redresseurs, ou mobiles d'une turbine à gaz, par exemple dans le domaine de l'aéronautique.

Il est connu d'utiliser des superalliages à base de nickel pour la fabrication d'aubes monocristallines fixes ou mobiles de turbines à gaz pour moteurs d'avion ou d'hélicoptère.

Ces matériaux ont pour principaux avantages de combiner à la fois une résistance au fluage élevée à haute température ainsi qu'une résistance à l'oxydation et à la corrosion. Le document EP1975261A1 divulgue un superalliage à base de nickel pour aubes monocristallines.

Au cours du temps, les superalliages à base de nickel pour aubes monocristallines ont subi d'importantes évolutions de composition chimique, dans le but notamment d'améliorer leurs propriétés en fluage à haute température tout en conservant une résistance à l'environnement très agressif dans lesquels ces superalliages sont utilisés.

Par ailleurs, des revêtements métalliques adaptés à ces alliages ont été développés afin d'augmenter leur résistance à l'environnement agressif dans lequel ces alliages sont utilisés, notamment la résistance à l'oxydation et la résistance à la corrosion. De plus, un revêtement céramique de faible conductivité thermique, remplissant une fonction de barrière thermique, peut être ajouté pour réduire la température à la surface du métal.

Typiquement, un système de protection complet comporte au moins deux couches.

La première couche, aussi appelée sous-couche ou couche de liaison, est directement déposée sur la pièce à protéger en superalliage à base de nickel, aussi appelée substrat, par exemple une aube. L'étape de dépôt est suivie d'une étape de diffusion de la sous-couche dans le superalliage. Le dépôt et la diffusion peuvent également être réalisés lors d'une seule étape.

Les matériaux généralement utilisés pour réaliser cette sous-couche comprennent des alliages métalliques aluminoformeurs de type MCrAIY (M = Ni (nickle) ou Co (cobalt) ou un mélange de Ni et de Co, Cr = chrome, Al = aluminium et Y = yttrium) ou des alliages de type aluminiure de nickel (NiₓAl_{y}), certains contenant également du platine (NiₓAlᵥPt_{z}).

La deuxième couche, généralement appelée barrière thermique ou « TBC » conformément à l'acronyme anglais pour « Thermal Barrier Coating », est un revêtement céramique comprenant par exemple de la zircone yttriée, aussi appelée « YSZ » conformément à l'acronyme anglais pour « Yttria Stabilized Zirconia » ou « YPSZ » conformément à l'acronyme anglais pour « Yttria Partially Stabilized Zirconia » et présentant une structure poreuse. Cette couche peut être déposée par différents procédés, tels que l'évaporation sous faisceau d'électrons (« EB-PVD » conformément à l'acronyme anglais pour « Electron Beam Physical Vapor Déposition »), la projection thermique (« APS » conformément à l'acronyme anglais pour « Atmospheric Plasma Spraying »), « SPS » conformément à l'acronyme anglais pour « Suspension Plasma Spraying »), ou tout autre procédé permettant d'obtenir un revêtement céramique poreux à faible conductivité thermique.

Du fait de l'utilisation de ces matériaux à haute température, par exemple de 650°C à 1150°C, il se produit des phénomènes d'inter-diffusion à l'échelle microscopique entre le superalliage à base de nickel du substrat et l'alliage métallique de la sous-couche. Ces phénomènes d'inter-diffusion, associés à l'oxydation de la sous-couche, modifient notamment la composition chimique, la microstructure et par conséquent les propriétés mécaniques de la sous-couche dès la fabrication du revêtement, puis pendant l'utilisation de l'aube dans la turbine. Ces phénomènes d'inter-diffusion modifient également la composition chimique, la microstructure et par conséquent les propriétés mécaniques du superalliage du substrat. Dans les superalliages très chargés en éléments réfractaires, notamment en rhénium, il peut ainsi se former dans le superalliage sous la sous-couche une zone de réaction secondaire (ZRS) sur une profondeur de plusieurs dizaines, voire centaines, de micromètres. Les caractéristiques mécaniques de cette ZRS sont nettement inférieures à celles du superalliage du substrat. La formation de ZRS est indésirable car elle conduit à une réduction significative de la résistance mécanique du superalliage.

Ces évolutions de la couche de liaison, associées aux champs de contraintes liés à la croissance de la couche d'alumine qui se forme en service à la surface de cette couche de liaison, aussi appelée « TGO » conformément à l'acronyme anglais pour « Thermally Grown Oxide », et aux écarts de coefficients de dilatation thermique entre les différentes couches, génèrent des décohésions dans la zone interfaciale entre la sous-couche et le revêtement céramique, qui peuvent conduire à l'écaillage partiel ou total du revêtement céramique. La partie métallique (substrat en superalliage et sous-couche métallique) est alors mise à nu et exposée directement aux gaz de combustion, ce qui augmente les risques d'endommagement de l'aube et donc de la turbine à gaz.

### Objet et résumé de l'invention

Le présent exposé vise à proposer des compositions de superalliages à base de nickel pour la fabrication de composants monocristallins, montrant des caractéristiques mécaniques à très haute température supérieures à celles des alliages existants, et favorisant la résistance à l'écaillage de la barrière thermique.

A cet effet, le présent exposé concerne un superalliage à base de nickel comprenant, en pourcentages massiques, 4,0 à 6,0 % de chrome, 0,4 à 0,8 % de molybdène, 2,5 à 3,5 % de rhénium, 6,2 à 6,6 %de tungstène, 5,2 à 5,7 % d'aluminium, 0,0 à 1,6 % de titane, 6 à 9,9 % de tantale, 0 à 0,7 % de hafnium, 0,0 à 0,3 % de silicium, le complément étant constitué par du nickel et des impuretés éventuelles.

Ce superalliage est destiné à la fabrication de composants monocristallins de turbine à gaz, tels que des aubes fixes ou mobiles.

Grâce à cette composition du superalliage à base de nickel (Ni), la résistance au fluage est améliorée par rapport aux superalliages existants, en particulier à des températures pouvant aller jusqu'à 1200°C et l'adhérence de la barrière thermique est renforcée par rapport à celle observée sur les superalliages existants.

Cet alliage présente donc une résistance au fluage à haute température améliorée. La durée de vie de cet alliage étant ainsi longue, cet alliage présente également une résistance à la corrosion et à l'oxydation améliorée. Cet alliage peut aussi présenter une résistance en fatigue thermique améliorée.

Une pièce monocristalline en superalliage à base de nickel est obtenue par un procédé de solidification dirigée sous gradient thermique en fonderie à la cire perdue. Le superalliage monocristallin à base de nickel comprend une matrice austénitique de structure cubique à faces centrées, solution solide à base de nickel, dite phase gamma (« γ »). Cette matrice contient des précipités de phase durcissante gamma prime (« γ' ») de structure cubique ordonnée L1₂ de type Ni₃Al. L'ensemble (matrice et précipités) est donc décrit comme un superalliage γ/γ'.

Par ailleurs, cette composition du superalliage à base de nickel autorise la mise en œuvre d'un traitement thermique qui remet totalement en solution les précipités de phase γ' et les phases eutectiques γ/γ' qui se forment lors de la solidification du superalliage. On peut ainsi obtenir un superalliage monocristallin à base de nickel contenant des précipités γ' de taille contrôlée, de préférence comprise entre 300 et 500 nanomètres (nm), et exempts de phases eutectiques γ/γ'.

Le traitement thermique permet également de contrôler la fraction volumique des précipités de phase γ' présente dans le superalliage monocristallin à base de nickel. Le pourcentage en volume des précipités de phase γ' peut être supérieur ou égal à 50%, de préférence supérieur ou égal à 60%, encore plus de préférence égal à 70%.

L'addition de tungstène (W), de chrome (Cr), de rhénium (Re) ou de molybdène (Mo) permet principalement de renforcer la matrice austénitique y par durcissement en solution solide.

L'addition d'aluminium (Al), de titane (Ti) ou de tantale (Ta) favorise la précipitation de la phase durcissante γ'-Ni₃(Al, Ti, Ta).

Le rhénium (Re) permet de ralentir la diffusion des espèces chimiques au sein du superalliage et de limiter la coalescence des précipités de phase γ' en cours de service à haute température, phénomène qui entraîne une réduction de la résistance mécanique. Le rhénium permet ainsi d'améliorer la résistance au fluage à haute température du superalliage à base de nickel. Toutefois, une concentration trop élevée de rhénium peut entraîner la précipitation de phases intermétalliques, par exemple phase σ, phase P ou phase µ, présentant une topologie compacte, aussi appelées phases TCP conformément à l'acronyme anglais pour « Topologically Close-Packed », qui ont un effet négatif sur les propriétés mécaniques du superalliage. Une concentration trop élevée en rhénium peut également provoquer la formation d'une zone de réaction secondaire dans le superalliage sous la sous-couche, ce qui a un effet négatif sur les propriétés mécaniques du superalliage.

L'addition simultanée de silicium (Si) et de hafnium (Hf) permet d'améliorer la tenue à l'oxydation à chaud des superalliages à base de nickel en augmentant l'adhérence de la couche d'alumine (Al₂O₃) qui se forme à la surface du superalliage à haute température. Cette couche d'alumine forme une couche de passivation en surface du superalliage à base de nickel et une barrière à la diffusion de l'oxygène venant de l'extérieur vers l'intérieur du superalliage à base de nickel. Toutefois on peut ajouter du hafnium sans ajouter également de silicium ou inversement ajouter du silicium sans ajouter également du hafnium et quand même améliorer la tenue à l'oxydation à chaud du superalliage.

Par ailleurs, l'addition de chrome ou d'aluminium permet d'améliorer la résistance à l'oxydation et à la corrosion à haute température du superalliage. En particulier, le chrome est essentiel pour augmenter la résistance à la corrosion à chaud des superalliages à base de nickel. Toutefois, une teneur trop élevée en chrome tend à réduire la température de solvus de la phase γ' du superalliage à base de nickel, c'est-à-dire la température au-dessus de laquelle la phase γ' est totalement dissoute dans la matrice γ, ce qui est indésirable. Aussi, la concentration en chrome est comprise entre 4,0 à 6,0% en masse afin de conserver une température élevée de solvus de la phase γ' du superalliage à base de nickel, par exemple supérieure ou égale à 1250°C mais également pour éviter la formation des phases topologiquement compactes dans la matrice y fortement saturée en éléments d'alliages tels que rhénium, le molybdène ou le tungstène.

L'addition d'éléments réfractaires, tels que le molybdène, le tungstène, le rhénium ou le tantale permet de ralentir les mécanismes contrôlant le fluage des superalliages à base de nickel et qui dépendent de la diffusion des éléments chimiques dans le superalliage.

On notera également que le superalliage à base de nickel ne comprend pas de cobalt (Co), élément qui a pour effet de réduire la température de solvus de la phase γ'.

Par impuretés, on entend des éléments chimiques présents dans le métal de manière non désirée et en faible quantité, par exemple des éléments ayant une concentration massique inférieure ou égale à 0,05 %.

On entend par superalliages à base de nickel, des superalliages dont le pourcentage massique en nickel est majoritaire. On comprend que le nickel est donc l'élément dont le pourcentage massique dans l'alliage est le plus élevé.

Le superalliage peut comprendre, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,8 à 1,2 % de titane, 6,3 à 9,2 % de tantale, 0,3 à 0,7 % de hafnium, 0,0 à 0,3 % de silicium, le complément étant constitué par du nickel et des impuretés éventuelles.

Le superalliage peut comprendre, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,0 à 1,5 % de titane, 6,3 à 6,7 % de tantale, 0,3 à 0,7 % de hafnium, 0,0 à 0,3 % de silicium, le complément étant constitué par du nickel et des impuretés éventuelles.

Le superalliage peut comprendre, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,0 à 0,5 % de titane, 8,8 à 9,2 % de tantale, 0,3 à 0,7 % de hafnium, 0,0 à 0,3 % de silicium, le complément étant constitué par du nickel et des impuretés éventuelles.

Le superalliage peut comprendre, en pourcentages massiques, 5 % de chrome, 0,6 % de molybdène, 3 % de rhénium, 6,4 %de tungstène, 5,5 % d'aluminium, 1 % de titane, 6,5 % de tantale, 0,5 % d'hafnium, 0,0 à 0,1 % de silicium, le complément étant constitué par du nickel et des impuretés éventuelles.

Le superalliage peut comprendre, en pourcentages massiques, 5 % de chrome, 0,6 % de molybdène, 3 % de rhénium, 6,4 %de tungstène, 5,5 % d'aluminium, 9 % de tantale, 0,5 % de hafnium, 0,0 à 0,1 % de silicium, le complément étant constitué par du nickel et des impuretés éventuelles.

Le présent exposé concerne également une aube monocristalline pour turbomachine comprenant un superalliage tel que défini précédemment.

Cette aube présente donc une résistance au fluage à haute température améliorée.

L'aube peut comprendre un revêtement de protection comportant une sous-couche métallique déposée sur le superalliage et une barrière thermique céramique déposée sur la sous-couche métallique.

Grâce à la composition du superalliage à base de nickel, les phénomènes d'inter-diffusion entre le superalliage et la sous-couche réduisent, voire ne conduisent pas, à la formation d'une zone de réaction secondaire dans le superalliage.

Grâce à la composition du superalliage à base de nickel, la résistance à l'écaillage de la barrière thermique sur l'aube est renforcée par rapport au cas des aubes en superalliages à base de nickel de l'état de la technique.

La sous-couche métallique peut être un alliage de type MCrAlY ou des alliages de type aluminiure de nickel.

La barrière thermique céramique peut être un matériau à base de zircone yttriée ou tout autre revêtement céramique (à base de zircone) à faible conductivité thermique.

L'aube peut présenter une structure orientée selon une direction cristallographique <001>.

Cette orientation confère généralement les propriétés mécaniques optimales à l'aube.

Le présent exposé concerne aussi une turbomachine comprenant une aube telle que définie précédemment.

### Brève description des dessins

D'autres caractéristiques et avantages de l'invention ressortiront de la description suivante de modes de réalisation de l'invention, donnés à titre d'exemples non limitatifs, en référence à la figure unique annexée, sur lesquelles :

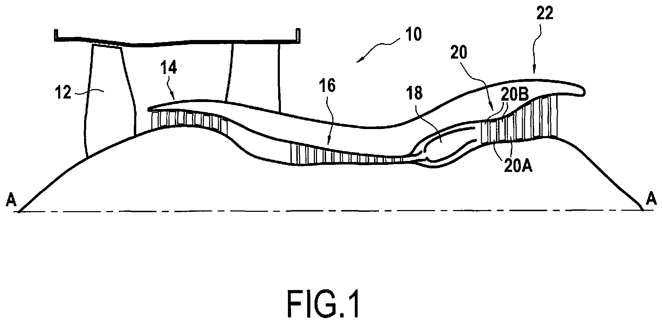

- la figure 1 est une vue schématique en coupe longitudinale d'une turbomachine.

### Description détaillée de l'invention

Les superalliages à base de nickel sont destinés à la fabrication d'aubes monocristallines par un procédé de solidification dirigée dans un gradient thermique. L'utilisation d'un germe monocristallin ou d'un sélecteur de grain en début de solidification permet d'obtenir cette structure monocristalline. La structure est orientée par exemple selon une direction cristallographique <001> qui est l'orientation qui confère, en général, les propriétés mécaniques optimales aux superalliages.

Les superalliages monocristallins à base de nickel bruts de solidification ont une structure dendritique et sont constitués de précipités γ' Ni₃(Al, Ti, Ta) dispersés dans une matrice γ de structure cubique à faces centrées, solution solide à base de nickel. Ces précipités de phase γ' sont répartis de façon hétérogène dans le volume du monocristal du fait de ségrégations chimiques résultant du procédé de solidification. Par ailleurs, des phases eutectiques γ/γ' sont présentes dans les régions inter-dendritiques et constituent des sites préférentiels d'amorçage de fissures. De plus, les phases eutectiques γ/γ' sont formées au détriment des fins précipités (taille inférieure au micromètre) de phase durcissante γ'. Ces précipités de phase γ' constituent la principale source de durcissement des superalliages à base de nickel. Aussi, la présence de phases eutectiques γ/γ' résiduelles ne permet pas d'optimiser la tenue au fluage à chaud du superalliage à base de nickel.

Il a en effet été montré que les propriétés mécaniques des superalliages, en particulier la résistance au fluage, étaient optimales lorsque la précipitation des précipités γ' était ordonnée, avec une taille allant de 300 à 500 nm, et lorsque la totalité des phases eutectiques γ/γ' était remise en solution.

Les superalliages à base de nickel bruts de solidification sont donc traités thermiquement pour obtenir la répartition désirée des différentes phases. Le premier traitement thermique est un traitement d'homogénéisation de la microstructure qui a pour objectif de dissoudre les précipités de phase γ' et les phases eutectiques γ/γ'. Ce traitement est réalisé à une température supérieure à la température de solvus de la phase γ'. Une trempe est ensuite réalisée à la fin de ce premier traitement thermique pour obtenir une dispersion fine et homogène des précipités γ'. Des traitements thermiques de revenu sont ensuite réalisés en deux étapes, à des températures inférieures à la température de solvus de la phase γ'. Lors d'une première étape, pour faire grossir les précipités γ' et obtenir la taille désirée, puis lors d'une seconde étape, pour faire croître la fraction volumique de cette phase jusqu'à environ 70%.

### Exemples

Deux superalliages monocristallins à base de nickel du présent exposé (Ex 1 et Ex 2) ont été étudiés et comparés à trois superalliages monocristallins commerciaux CMSX-4 (Ex 3), AM1 (Ex 4) et MC2 (Ex 5). La composition chimique de chacun des superalliages monocristallins est donnée dans le Tableau 1. Tous ces superalliages sont des superalliages à base de nickel, c'est-à-dire que le complément à 100 % des concentrations présentées au Tableau 1 est constitué par du nickel et des impuretés éventuelles.

**Tableau 1**

| | Co | Cr | Mo | Re | W | Al | Ti | Ta | Hf | Si |
|---|---|---|---|---|---|---|---|---|---|---|
| Ex 1 | - | 5 | 0,6 | 3 | 6,4 | 5,5 | 1 | 6,5 | 0,5 | 0,1 |
| Ex 2 | - | 5 | 0,6 | 3 | 6,4 | 5,5 | - | 9 | 0,5 | 0,1 |
| Ex 3 | 9 | 6,5 | 0,6 | 3 | 6 | 5,6 | 1 | 6,5 | 0,1 | - |
| Ex 4 | 6,5 | 7,5 | 2 | - | 5,5 | 5,3 | 1,2 | 8 | 0,1 | - |
| Ex 5 | 5 | 8 | 2 | - | 8 | 5 | 1,5 | 6 | 0,1 | 0,1 |

### Tenue au fluage

Le tableau 2 présente les résultats d'un test de résistance en fluage sous argon (Ar) à 1200°C en appliquant une contrainte de 80 MPa, réalisé sur les superalliages Ex 1 à Ex 5. La résistance en fluage est quantifiée par la durée de vie exprimée en heures (h) de l'éprouvette, c'est-à-dire le temps écoulé entre le début de la mise sous charge à 1200°C et la rupture de l'éprouvette.

**Tableau 2**

| Superalliages | Durée de vie (h) |
|---|---|
| Ex 1 | 90 |
| Ex 2 | 50 |
| Ex 3 | 25 |
| Ex 4 | 4 |
| Ex 5 | 3 |

Comme on peut le constater, les superalliages Ex 1 et Ex 2 présentent une durée de vie en fluage à rupture, largement supérieure à celle des superalliages de comparaison CMSX-4 (Ex 3), AM1 (Ex 4) et MC2 (Ex 5). Les superalliages Ex 1 et Ex 2 peuvent donc soit supporter des contraintes en fonctionnement supérieures à celles que peuvent supporter les superalliages de comparaison, pour des durées de vie comparables, soit montrer des durées de vie supérieures sous des contraintes comparables.

### Tenue du revêtement de protection

Afin d'étudier la compatibilité des superalliages Ex 1 à Ex 5 avec le revêtement (sous-couche métallique et barrière thermique céramique), des essais de tenue de la barrière thermique en oxydation cyclique ont été réalisés.

Ces essais, réalisés sous air, sont constitués de la répétition d'un cycle thermique élémentaire comprenant une étape de chauffage jusqu'à 1100°C pendant une dizaine de minutes, suivie d'un maintien à 1100°C, la durée cumulée de ces deux étapes étant de 1 h, et d'un refroidissement forcé pendant une douzaine de minutes jusqu'à une température inférieure à 100°C.

L'essai est arrêté lorsque l'éprouvette présente un écaillage de la barrière thermique céramique sur au moins 20% de la surface de l'éprouvette, c'est-à-dire lorsque la barrière thermique céramique est présente sur moins de 80% de la surface de l'éprouvette. Cette mesure peut être réalisée par analyse d'images.

Les superalliages Ex 1 à Ex 5 ont été revêtus d'une sous-couche métallique de type NiPtAl puis d'une barrière thermique céramique de type zircone yttriée déposée par EB-PVD. La zircone yttriée est du type 8YPSZ qui est une zircone yttriée comprenant 8% en masse d'oxyde d'yttrium (Y₂O₃).

Les résultats de ces essais sont rapportés dans le Tableau 3 qui présente le nombre de cycles à 1100°C réalisés sur chaque éprouvette avant que l'essai soit arrêté.

La dispersion des résultats des différents essais réalisés sur un type de superalliage est représentée par l'incertitude exprimée en nombre de cycles pouvant être ajoutés ou soustraits de la valeur du nombre de cycles de la colonne 2 du Tableau 3. Pour chaque alliage, l'essai a été réalisé sur au moins trois éprouvettes distinctes.

**Tableau 3**

| Superalliages | Nombre de cycles | Incertitude (nombre de cycles) |
|---|---|---|
| Ex 1 | 4500 | 500 |
| Ex 2 | 4300 | 500 |
| Ex 3 | 2050 | 500 |
| Ex 4 | 1450 | 250 |

On constate que les éprouvettes ayant pour substrat les compositions Ex 1 et Ex 2 peuvent subir un nombre de cycles entre 1100°C et la température inférieure à 100°C en atmosphère oxydante bien plus élevé que les éprouvettes ayant pour substrat les compositions Ex 3 et Ex 4 avant que la barrière thermique ne s'écaille sur plus de 20% de la surface de l'éprouvette.

La microstructure des éprouvettes revêtues ayant pour substrat les compositions Ex 1 et Ex 2 a été contrôlée à l'issue des essais de cyclage thermique entre 1100°C et la température inférieure à 100°C. Les observations par microscopie optique démontrent l'absence de zone de réaction secondaire dans le substrat en superalliage sous la sous-couche métallique de type NiPtAl.

En conclusion, les superalliages du présent exposé présentent, d'une part, des propriétés en fluage supérieures à celles des alliages commerciaux CMSX-4, AM1 et MC2 (Ex 3 à Ex 5) à très haute température (1200°C). D'autre part, ces superalliages permettent d'améliorer la durée de vie de la barrière thermique. Enfin, ces alliages ne sont pas sensibles à la formation d'une zone de réaction secondaire sous le revêtement de la barrière thermique. Ces superalliages permettent ainsi d'augmenter la durée de vie des pièces (aubes de turbine par exemple) à haute température qui sont réalisées à partir de ces superalliages, notamment lorsque ces pièces comprennent un revêtement de protection.

La figure 1 représente, en coupe selon un plan vertical passant par son axe principal A, un turboréacteur à double flux 10. Le turboréacteur à double flux 10 comporte, d'amont en aval selon la circulation du flux d'air, une soufflante 12, un compresseur basse pression 14, un compresseur haute pression 16, une chambre de combustion 18, une turbine haute pression 20, et une turbine basse pression 22.

La turbine haute pression 20 comprend une pluralité d'aubes mobiles 20A tournant avec le rotor et de redresseurs 20B (aubes fixes) montés sur le stator. Le stator de la turbine 20 comprend une pluralité d'anneaux 24 de stator disposés en vis-à-vis des aubes mobiles 20A de la turbine 20.

Ces propriétés font ainsi de ces superalliages des candidats intéressants pour la fabrication de pièces monocristallines destinées aux parties chaudes des turboréacteurs.

On peut donc fabriquer une aube mobile 20A ou un redresseur 20B pour turbomachine comprenant un superalliage tel que définit précédemment.

On peut également fabriquer une aube mobile 20A ou un redresseur 20B pour turbomachine comprenant un superalliage tel que défini(e) précédemment revêtu(e) d'un revêtement de protection comprenant une sous-couche métallique

Une turbomachine peut notamment être un turboréacteur tel qu'un turboréacteur à double flux 10. La turbomachine peut également être un turboréacteur à simple flux, un turbopropulseur ou un turbomoteur.

Quoique le présent exposé ait été décrit en se référant à un exemple de réalisation spécifique, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels. Par conséquent, la description et les dessins doivent être considérés dans un sens illustratif plutôt que restrictif.

## Revendications

1. Superalliage à base de nickel comprenant, en pourcentages massiques, 4,0 à 6,0 % de chrome, 0,4 à 0,8 % de molybdène, 2,5 à 3,5 % de rhénium, 6,2 à 6,6 %de tungstène, 5,2 à 5,7 % d'aluminium, 0,0 à 1,6 % de titane, 6,0 à 9,9 % de tantale, 0,0 à 0,7 % de hafnium, 0,0 à 0,3 % de silicium, le complément étant constitué par du nickel et des impuretés éventuelles.

2. Superalliage selon la revendication 1, comprenant, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,8 à 1,2 % de titane, 6,3 à 9,2 % de tantale, 0,3 à 0,7 % de hafnium, 0,0 à 0,3 % de silicium, le complément étant constitué par du nickel et des impuretés éventuelles.

3. Superalliage selon la revendication 1, comprenant, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,0 à 1,5 % de titane, 6,3 à 6,7 % de tantale, 0,3 à 0,7 % de hafnium, 0,0 à 0,3 % de silicium, le complément étant constitué par du nickel et des impuretés éventuelles.

4. Superalliage selon la revendication 1, comprenant, en pourcentages massiques, 4,8 à 5,2 % de chrome, 0,4 à 0,8 % de molybdène, 2,8 à 3,2 % de rhénium, 6,2 à 6,6 %de tungstène, 5,2 à 5,7 % d'aluminium, 0,0 à 0,5 % de titane, 8,8 à 9,2 % de tantale, 0,3 à 0,7 % de hafnium, 0,0 à 0,3 % de silicium, le complément étant constitué par du nickel et des impuretés éventuelles.

5. Superalliage selon la revendication 1, comprenant, en pourcentages massiques, 5 % de chrome, 0,6 % de molybdène, 3 % de rhénium, 6,4 %de tungstène, 5,5 % d'aluminium, 1 % de titane, 6.5 % de tantale, 0.5 % de hafnium, 0,0 à 0.1 % de silicium, le complément étant constitué par du nickel et des impuretés éventuelles.

6. Superalliage selon la revendication 1, comprenant, en pourcentages massiques, 5 % de chrome, 0,6 % de molybdène, 3 % de rhénium, 6,4 %de tungstène, 5,5 % d'aluminium, 9 % de tantale, 0,5 % de hafnium, 0,0 à 0,1 % de silicium, le complément étant constitué par du nickel et des impuretés éventuelles.

7. Aube (20A, 20B) monocristalline pour turbomachine comprenant un superalliage selon l'une quelconque des revendications 1 à 6.

8. Aube (20A, 20B) selon la revendication 7, comprenant un revêtement de protection comportant une sous-couche métallique déposée sur le superalliage et une barrière thermique céramique déposée sur la sous-couche métallique.

9. Aube (20A, 20B) selon la revendication 7 ou 8, présentant une structure orientée selon une direction cristallographique <001>.

10. Turbomachine comprenant une aube (20A, 20B) selon l'une quelconque des revendications 7 à 9.

## Patentansprüche

1. Superlegierung auf der Basis von Nickel, umfassend, in Gewichtsprozent, 4,0 bis 6,0 % Chrom, 0,4 bis 0,8 % Molybdän, 2,5 bis 3,5 % Rhenium, 6,2 bis 6,6 % Wolfram, 5,2 bis 5,7 % Aluminium, 0,0 bis 1,6 % Titan, 6,0 bis 9,9 % Tantal, 0,0 bis 0,7 % Hafnium, 0,0 bis 0,3 % Silizium, wobei der Rest aus Nickel und etwaigen Verunreinigungen besteht.

2. Superlegierung nach Anspruch 1, umfassend, in Gewichtsprozent, 4,8 bis 5,2 % Chrom, 0,4 bis 0,8 % Molybdän, 2,8 bis 3,2 % Rhenium, 6,2 bis 6,6 % Wolfram, 5,2 bis 5,7 % Aluminium, 0,8 bis 1,2 % Titan, 6,3 bis 9,2 % Tantal, 0,3 bis 0,7 % Hafnium, 0,0 bis 0,3 % Silizium, wobei der Rest aus Nickel und etwaigen Verunreinigungen besteht.

3. Superlegierung nach Anspruch 1, umfassend, in Gewichtsprozent, 4,8 bis 5,2 % Chrom, 0,4 bis 0,8 % Molybdän, 2,8 bis 3,2 % Rhenium, 6,2 bis 6,6 % Wolfram, 5,2 bis 5,7 % Aluminium, 0,0 bis 1,5 % Titan, 6,3 bis 6,7 % Tantal, 0,3 bis 0,7 % Hafnium, 0,0 bis 0,3 % Silizium, wobei der Rest aus Nickel und etwaigen Verunreinigungen besteht.

4. Superlegierung nach Anspruch 1, umfassend, in Gewichtsprozent, 4,8 bis 5,2 % Chrom, 0,4 bis 0,8 % Molybdän, 2,8 bis 3,2 % Rhenium, 6,2 bis 6,6 % Wolfram, 5,2 bis 5,7 % Aluminium, 0,0 bis 0,5 % Titan, 8,8 bis 9,2 % Tantal, 0,3 bis 0,7 % Hafnium, 0,0 bis 0,3 % Silizium, wobei der Rest aus Nickel und etwaigen Verunreinigungen besteht.

5. Superlegierung nach Anspruch 1, bestehend aus, in Gewichtsprozent, 5 % Chrom, 0,6 % Molybdän, 3 % Rhenium, 6,4 % Wolfram, 5,5 % Aluminium, 1 % Titan, 6,5 % Tantal, 0,5 % Hafnium, 0,0 bis 0,1 % Silizium, wobei der Rest aus Nickel und etwaigen Verunreinigungen besteht.

6. Superlegierung nach Anspruch 1, umfassend, in Gewichtsprozent, 5 % Chrom, 0,6 % Molybdän, 3 % Rhenium, 6,4 % Wolfram, 5,5 % Aluminium, 9 % Tantal, 0,5 % Hafnium, 0,0 bis 0,1 % Silizium, wobei der Rest aus Nickel und etwaigen Verunreinigungen besteht.

7. Einkristalline Turbinenschaufel (20A, 20B) für eine Strömungsmaschine, umfassend eine Superlegierung nach einem der Ansprüche 1 bis 6.

8. Turbinenschaufel (20A, 20B) nach Anspruch 7, umfassend eine Schutzbeschichtung, die eine auf der Superlegierung abgeschiedene metallische Unterschicht und eine auf der metallischen Unterschicht abgeschiedene keramische Wärmesperre umfasst.

9. Turbinenschaufel (20A, 20B) nach Anspruch 7 oder 8 mit einer Struktur, die in einer kristallographischen Richtung <001> orientiert ist.

10. Strömungsmaschine mit einer Turbinenschaufel (20A, 20B) nach einem der Ansprüche 7 bis 9.

## Claims

1. A nickel-based superalloy including, in mass percent: 4.0% to 6.0% chromium; 0.4% to 0.8% molybdenum; 2.5% to 3.5% rhenium; 6.2% to 6.6% tungsten; 5.2% to 5.7% aluminum; 0.0 to 1.6% titanium; 6.0% to 9.9% tantalum; 0.0 to 0.7% hafnium; and 0.0 to 0.3% silicon; the balance being constituted by nickel and any impurities.

2. A superalloy according to claim 1, including, in mass percent: 4.8% to 5.2% chromium; 0.4% to 0.8% molybdenum; 2.8% to 3.2% rhenium; 6.2% to 6.6% tungsten; 5.2% to 5.7% aluminum; 0.8% to 1.2% titanium; 6.3% to 9.2% tantalum; 0.3% to 0.7% hafnium; and 0.0 to 0.3% silicon; the balance being constituted by nickel and any impurities.

3. A superalloy according to claim 1, including, in mass percent: 4.8% to 5.2% chromium; 0.4% to 0.8% molybdenum; 2.8% to 3.2% rhenium; 6.2% to 6.6% tungsten; 5.2% to 5.7% aluminum; 0.0 to 1.5% titanium; 6.3% to 6.7% tantalum; 0.3% to 0.7% hafnium; and 0.0 to 0.3% silicon; the balance being constituted by nickel and any impurities.

4. A superalloy according to claim 1, including, in mass percent: 4.8% to 5.2% chromium; 0.4% to 0.8% molybdenum; 2.8% to 3.2% rhenium; 6.2% to 6.6% tungsten; 5.2% to 5.7% aluminum; 0.0 to 0.5% titanium; 8.8% to 9.2% tantalum; 0.3% to 0.7% hafnium; and 0.0 to 0.3% silicon; the balance being constituted by nickel and any impurities.

5. A superalloy according to claim 1, including, in mass percent: 5% chromium; 0.6% molybdenum; 3% rhenium; 6.4% tungsten; 5.5% aluminum; 1% titanium; 6.5% tantalum; 0.5% hafnium; and 0.0 to 0.1% silicon; the balance being constituted by nickel and any impurities.

6. A superalloy according to claim 1, including, in mass percent: 5% chromium; 0.6% molybdenum; 3% rhenium; 6.4% tungsten; 5.5% aluminum; 9% tantalum; 0.5% hafnium; and 0.0 to 0.1% silicon; the balance being constituted by nickel and any impurities.

7. A monocrystalline blade (20A, 20B) for a turbine engine, the blade comprising a superalloy according to any one of claims 1 to 6.

8. A blade (20A, 20B) according to claim 7, including a protective coating comprising a metal bond coat layer deposited on the superalloy and a ceramic thermal barrier deposited on the metal bond coat layer.

9. A blade (20A, 20B) according to claim 7 or claim 8, presenting a structure oriented in a <001> crystallographic direction.

10. A turbomachine including a blade (20A, 20B) according to any one of claims 7 to 9.
